# FASCICULE DE BREVET EUROPEEN

(11) **EP 1 846 320 B1**
(45) Date de publication et mention de la délivrance du brevet: **25.06.2008**
(21) Numéro de dépôt: 06709238.7
(22) Date de dépôt: 02.02.2006
(51) Int. Cl.: B81B 3/00, H01H 50/00

(54) **DISPOSITIF MICROMECANIQUE COMPORTANT UNE POUTRE MOBILE**
MIKROMECHANISCHE VORRICHTUNG MIT EINEM BEWEGLICHEN BALKEN
MICROMECHANICAL DEVICE COMPRISING A MOBILE BEAM

(30) Priorité: 08.02.2005 FR 0501239
(43) Date de publication de la demande: 24.10.2007
(73) Titulaire: COMMISSARIAT A L'ENERGIE ATOMIQUE, 75015 Paris (FR)
(72) Inventeur: FLEURY, Gatien, F-38000 Grenoble (FR); CHARVET, Pierre-Louis, F-38950 Saint-Martin-Le-Vinoux (FR)
(74) Mandataire: Jouvray, Marie-Andrée
(86) Numéro de dépôt international: PCT/FR2006/000246
(87) Numéro de publication internationale: WO 2006/084977

(56) Documents cités:
- DE-A1- 10 061 205
- US-A1- 2002 136 485
- US-B1- 6 218 762
- US-B1- 6 784 771

## Description

### Domaine technique de l'invention

L'invention concerne un dispositif micromécanique comportant une poutre mobile rattachée par ses deux extrémités à un cadre rigide, la poutre ayant un état de contrainte prédéterminé.

### État de la technique

Les dispositifs micromécaniques comportant une poutre mobile permettent de réaliser des résonateurs, des capacités variables, des miroirs optiques à large déflexion, des mémoires non-volatiles, des capteurs de force, des accéléromètres, des micro-commutateurs bistable ou non bistables, etc... L'un des problèmes majeurs pour le fonctionnement, et lors de la fabrication, des dispositifs micromécaniques comportant une poutre mobile sont les contraintes résiduelles, en particulier dans la poutre. Les contraintes résiduelles se répercutent, par exemple, sur la tension d'actionnement d'un commutateur et sur la fiabilité du dispositif. En particulier, les dispositifs nécessitent souvent des tensions d'actionnement fortes. Les contraintes résiduelles de la poutre influent aussi sur la déflexion verticale au milieu de la poutre (sa flèche). La valeur initiale de la flèche détermine la valeur de la capacité variable d'un condensateur ou détermine la force de contact et la stabilité d'un micro-commutateur bistable. L'état de contrainte de la poutre est déterminé, en particulier, par les contraintes résiduelles apportées par les procédés de dépôt des matériaux utilisés (l'état de contrainte est lié aussi à la géométrie de la poutre).

Le document DE10061205 divulgue un dispositif micromécanique comportant une suspension qui permet de contrôler l'état de contrainte d'une membrane.

### Objet de l'invention

L'invention a pour but de remédier à ces inconvénients et, en particulier, de réaliser un dispositif permettant de diminuer l'énergie nécessaire, par exemple la tension d'actionnement d'un dispositif micromécanique commandé électrostatiquement ou le courant d'actionnement d'un dispositif commandé par dilatation thermique, et de contrôler la flèche.

Ce but est atteint par un dispositif selon la revendication 1.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels:
La figure 1 illustre, en vue de dessus, un mode de réalisation particulier d'un dispositif selon l'invention.
Les figures 2 et 3 représentent, en coupe selon l'axe A-A, deux modes de réalisation particuliers d'un dispositif selon la figure 1.
Les figures 4 et 5 représentent schématiquement, en vue de dessus, deux autres modes de réalisation particuliers d'un dispositif selon l'invention.
Les figures 6 et 7 illustrent, respectivement en vue de dessus et en coupe selon l'axe B-B, un autre mode de réalisation particulier d'un dispositif selon l'invention.

### Description de modes particuliers de réalisation

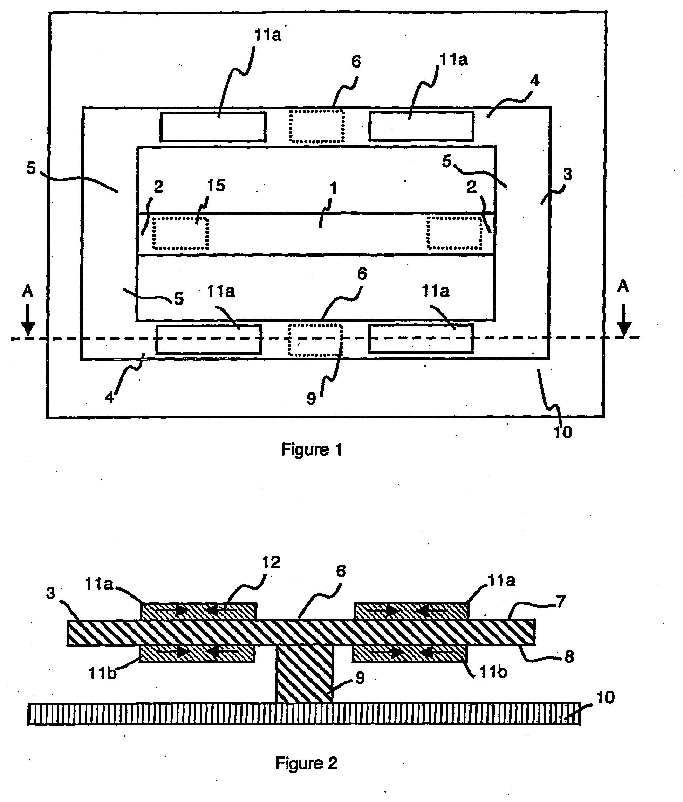

Sur la figure 1, un dispositif micromécanique comporte une poutre mobile 1 rattachée par ses deux extrémités 2 à un cadre 3 rigide, de préférence, un cadre plan. La poutre 1 est, par exemple, réalisée en silice (SiO2), en nitrure de silicium (Si3N4) ou en silicium monocristallin ou polycristallin. Le cadre 3 peut, par exemple, également être réalisé en silice (SiO2), en nitrure de silicium (Si3N1) ou en silicium monocristallin ou polycristallin, éventuellement accompagné d'un métal ou de plusieurs métaux ou d'un composé nitrure à base de métal, par exemple le TaN ou le TiN, ou d'un matériau piézoélectrique, par exemple le AIN. Dans un mode de réalisation particulier, le cadre 3 est réalisé par une couche de silice de type faible contrainte (SiO2 low stress) obtenu par un procédé PECVD qui forme également la poutre 1. La partie de cette couche qui correspond au cadre 3, peut également comporter des couches de nitrure de silicium (déposées par exemple par dépôt plasma à haute fréquence).

Le cadre 3 comporte deux bras 4 ayant chacun deux extrémités 5 respectivement solidaires des deux extrémités 2 de la poutre mobile 1. Chaque bras 4 a une partie médiane 6 disposée entre les deux extrémités 5 du bras 4 correspondant

Le cadre 3 doit être rigide par rapport à la poutre mobile 1, c'est-à-dire la faculté du cadre 3 à se déformer suite à une contrainte appliquée par la poutre 1 sur le cadre 3 est négligeable. Par exemple, lorsque la poutre 1 est sous contrainte maximale lors du fonctionnement du dispositif micromécanique, la déformation relative du cadre 3 est inférieure à 0,01%. L'épaisseur du cadre 3 est, par exemple, trois fois plus importante que l'épaisseur de la poutre 1 et la largeur de chaque bras 4 est, par exemple, dix fois plus importante que son épaisseur. La largeur de la poutre 1 peut être comparable à celle des bras 4, de manière à ce que la section des bras 4 soit environ trois fois plus importante que celle de la poutre 1. De plus, le matériau des bras 4 présente, de préférence, un module de Young supérieur au module de Young du matériau de la poutre 1. Pour réaliser un micro-commutateur bistable, la poutre 1 a typiquement une longueur de 500 microns et une largeur de 50 microns et les bras ont une largeur de 100microns.

Comme représenté à la figure 2, les bras 4 du cadre 3 et la partie médiane 6 présentent une face avant 7 et une face arrière 8. La partie médiane 6 de chaque bras 4 peut être disposée avec ladite face arrière 8 sur un socle 9 solidaire d'un support 10 de base, de manière à ce que le cadre 3 et la poutre 1 soient à l'écart du support de base 10. Le support 10 de base est, par exemple, plan.

Dans un premier mode de réalisation particulier de l'invention, le cadre 3 comporte au moins une paire d'éléments 11 sous contrainte avant 11 a et arrière 11b disposés, l'un en regard de l'autre, respectivement à la face avant 7 et à la face arrière 8 des bras 4. Sur la figure 1, le cadre 3 comporte quatre paires d'éléments 11 sous contrainte, notamment deux paires pour chaque bras 4 disposées respectivement de part et d'autre de la partie médiane 6 du bras 4 correspondant. Sur la figure 2 sont représentées deux paires d'éléments 11 avant (11a) et arrière (11b) disposées, sur les bras, respectivement de part et d'autre de la partie médiane 6 et, ainsi, du socle 9. Une première paire d'éléments avant (11 a) et arrière (11 b) est disposée à gauche sur la figure 2, et une seconde paire d'éléments avant (11 a) et arrière (11 b) est disposée à droite sur la figure 2.

Les éléments 11 permettent de contrôler l'état de contrainte de la poutre 1 mobile et, ainsi, d'ajuster la contrainte de compression ou de traction de la poutre 1. Ceci permet notamment de contrôler la déformation de la poutre 1.

Les éléments 11 sous contrainte peuvent être constitués de couches minces sous contrainte en traction ou de couches minces sous contrainte en compression. Chaque élément 11 peut également être constitué d'un empilement de couches minces. Les éléments 11 représentés à la figure 2 sont des couches minces sous contrainte en traction, comme représenté par des flèches 12. Ainsi, lorsque la poutre 1 est sous une contrainte en compression, cette contrainte en compression est augmentée, tandis qu'une contrainte en traction de la poutre 1 est réduite par une contrainte en traction des éléments 11. Pour les commutateurs bistables, la poutre 1 est, de préférence, sous forte compression, ce qui permet d'obtenir deux états d'équilibres très stables. Il est à noter que la poutre présente alors une contrainte longitudinale. La contrainte est ajustée avant le mouvement principal de la poutre, c'est-à-dire la poutre ne se déplace pas lorsque la contrainte est ajustée.

On peut obtenir deux positions stables en faisant flamber la poutre 1, ce qui nécessite que la force due aux contraintes en compression de la poutre 1 soit supérieure à la première charge critique d'Euler. Les contraintes en compression sont dues, d'une part, aux contraintes propres à la poutre 1, c'est-à-dire les contraintes résiduelles dues au procédé de dépôt, et, d'autre part, aux contraintes en traction des éléments 11 du cadre 3, provoquant l'augmentation de la contrainte en compression de la poutre 1.

Lorsque les éléments 11 sont disposés sur les deux faces des bras 4, la face avant 7 et la face arrière 8, un effet de type bilame, exerçant une force transversale aux bras 4, est évité. Les contraintes créent, ainsi, essentiellement des forces longitudinales dans les bras 4. Lorsque l'élément avant 11a d'une paire d'éléments n'a pas la même épaisseur, la même contrainte résiduelle et le même module de Young que l'élément arrière 11b correspondant, les épaisseurs des éléments 11a et 11b doivent être adaptées, afin d'éviter tout effet de type bilame. Pour déterminer l'épaisseur, on peut avoir par le calcul une première valeur en utilisant la loi de Hooke, connue de la mécanique des milieux continus, loi qui relie la contrainte résiduelle à la déformation. Puis l'homme du métier peut procéder par essais successifs. En effet, les caractéristiques (module élastique, contraintes résiduelles) des matériaux déposés en couche mince ayant une épaisseur inférieure au micromètre est mal connu. Dans tous les cas, une force avant exercée sur un des bras 4 par l'élément 11a avant d'une paire d'éléments est, de préférence, sensiblement égale à une force arrière exercée sur le même bras 4 par l'élément arrière 11b correspondant. Afin d'adapter les éléments avant 11 a et arrière 11 b, une autre solution envisageable est d'inclure des motifs situés dans le cadre où est encastrée la poutre qui rigidifieront les éléments 11, par exemple des raies dans le sens longitudinal des bras 4.

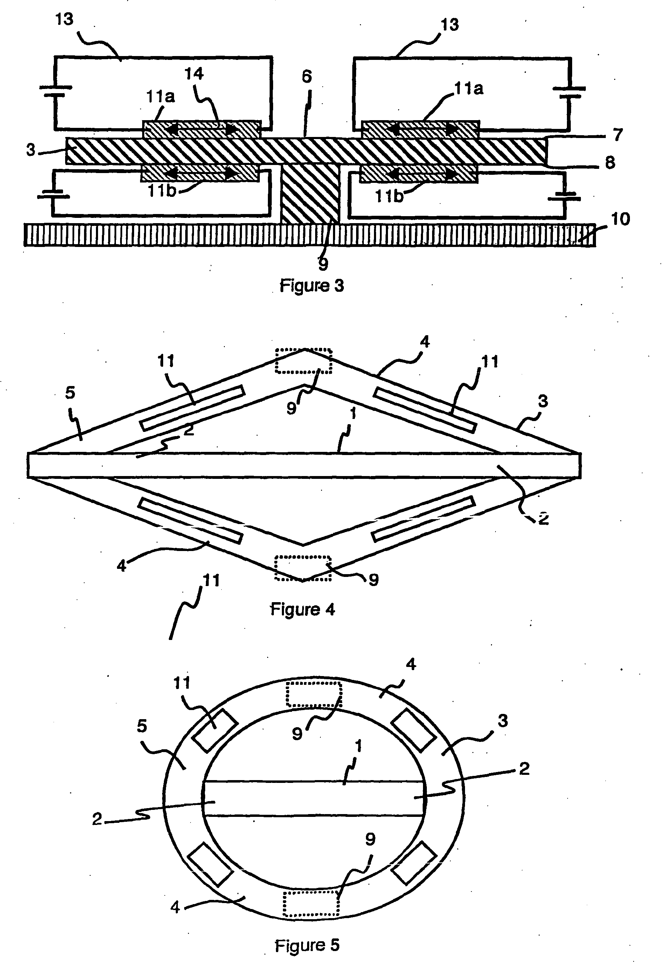

Dans une variante, les éléments 11 sous contrainte peuvent comporter des premiers actionneurs. De préférence, chaque élément 11 est constitué par un premier actionneur, comme représenté à la figure 3. Les premiers actionneurs sont disposés respectivement à la face avant 7 et à la face arrière 8 des bras 4. Ainsi, dans cette variante, les éléments 11 avant et arrière sont actifs, tandis que dans le mode de réalisation décrit précédemment, les éléments 1 avant et arrière sont passifs.

Les premiers actionneurs constituant les éléments 11 sont notamment intéressants dans le cas des commutateurs bistables. Les commutateurs bistables comportent éventuellement, de plus, des seconds actionneurs 15 pour l'actionnement de la poutre 1, représenté à la figure 1. L'actionnement de la poutre 1 par l'intermédiaire des seconds actionneurs 15 permet, par exemple dans le cas d'un micro-commutateur, d'établir un contact électrique entre dès éléments conducteurs disposés respectivement à une face inférieure de la poutre 1 et sur le support 10.

Grâce aux premiers actionneurs, on peut relâcher les contraintes résiduelles lors de la commutation qui est réalisée par les seconds actionneurs. Ceci permet d'éviter l'apparition de contraintes élevées qui peuvent entraîner la rupture de la poutre 1 mobile. Un commutateur bistable selon l'invention permet d'obtenir une grande force de contact et une haute stabilité des positions d'équilibre tout en rendant possible la commutation. Le commutateur résiste alors mieux aux influences du milieu extérieur, par exemple aux chocs ou aux champs de forces ou de potentiel extérieurs.

Les premiers actionneurs des éléments 11 permettent de modifier les contraintes dans le cadre 3 et, ainsi, de diminuer des contraintes internes de compression et de traction de la poutre 1. Ceci permet de faciliter le passage du commutateur d'une première position à une seconde position. Les premiers actionneurs sont, de préférence, choisis parmi les actionneurs thermiques, les actionneurs piézoélectriques et les actionneurs électrostatiques, électrostrictifs, électromagnétiques et magnétostrictifs. Les premiers actionneurs sont, par exemple, des actionneurs constitués de couches minces.

Dans le cas des actionneurs piézoélectriques, les couches constituant les premiers actionneurs sont, par exemple, en nitrure d'aluminium, en un composé comportant du zirconium, du titane, du plomb et de l'oxygène comme le Pb(Zr,Ti)O₃ ou en un composé comportant du magnésium, du zirconium, du niobium, du plomb et de l'oxygène comme le xPb(Mg_{1/3}Nb_{2/3})O₃(1-x)PbTi0₃. On peut envisager un dispositif utilisant deux types d'actionneurs différents. Sur la figure 3, des alimentations électriques 13 permettent d'appliquer une tension électrique aux extrémités de chacune des couches minces constituant les premiers actionneurs, de manière à obtenir une contrainte, par exemple en compression, illustrée par des flèches 14. La contrainte peut également être une contrainte en traction. Lors de l'actionnement, on obtient un allongement ou un raccourcissement longitudinal des bras 4, sans provoquer une flexion en direction du support 10 ou en s'éloignant du support.

Les actionneurs thermiques sont, par exemple, constitués par des couches métalliques. Lorsque les couches métalliques sont parcourues par un courant électrique, leur volume augmente, ce qui permet d'exercer une force de traction sur le cadre 3. On choisit, de préférence, un métal ayant un fort coefficient de dilatation thermique, une faible capacité calorifique, une bonne tenue en température et un module de Young élevé. Avantageusement, on donnera à cette couche mince, lors de l'étape de lithographie, une forme particulière apte à augmenter la déformation longitudinale de la poutre 1.

La poutre 1 peut, par exemple, comporter quatre seconds actionneurs 15, notamment deux seconds actionneurs 15 disposés à la face inférieure de la poutre 1 et deux seconds actionneurs 15 disposés à la face supérieure de la poutre 1, ce qui permet de réaliser l'actionnement de la poutre 1 en utilisant uniquement les seconds actionneurs 15. Dans une autre variante, la poutre 1 comporte seulement deux seconds actionneurs 15, ce qui permet de privilégier une position de stabilité de la poutre 1, par exemple une position du haut lorsque deux éléments sous contrainte en traction sont placés sur la face supérieure de la poutre 1 ou une position du bas lorsque deux éléments sous contrainte en compression sont placés sur la face supérieure de la poutre 1. Dans ce deuxième cas, on doit utiliser les seconds actionneurs 15 et les premiers actionneurs pour passer dans une position de moindre stabilité, tandis que, pour passer dans la position de stabilité la plus haute, il suffit d'actionner les premiers actionneurs uniquement.

Le dispositif selon l'invention peut avoir une géométrie quelconque. Ainsi, comme représenté aux figures 4 et 5, le cadre 3 peut présenter la géométrie d'un losange ou d'un cercle. Les éléments 11 peuvent, par exemple, recouvrir la totalité des bras 4 du cadre 3.

Pour les résonateurs et les condensateurs variables, on peut ajuster respectivement la fréquence de résonance et la valeur initiale de la capacité. Dans le cas d'un capteur de force, le seuil de déclenchement peut être ajusté. Dans un commutateur non-bistable, la tension d'actionnement peut être ajustée et notamment diminuée, ce qui permet de réduire la tension électrique d'actionnement. Tous ces ajustements peuvent être effectués avant ou pendant le fonctionnement des dispositifs.

Une couche sous contrainte en compression peut, par exemple, être réalisé par dépôt d'une couche en silice ou à base de nitrure de silicium déposée par plasma basse fréquence. Une couche sous contrainte en traction peut être réalisée par dépôt d'un nitrure de silicium (par exemple par dépôt plasma à haute fréquence), d'un nitrure de tantale (TaN) ou de titane (TiN) ou d'un métal, par exemple le tantale, le platine, l'or, l'argent, l'aluminium, le manganèse, le zinc et le nickel ou d'un alliage à base de nickel (par exemple de l'inconel FeNiCr). Les métaux ont l'avantage de posséder un coefficient de dilatation thermique important, ce qui implique un bon potentiel de dilatation.

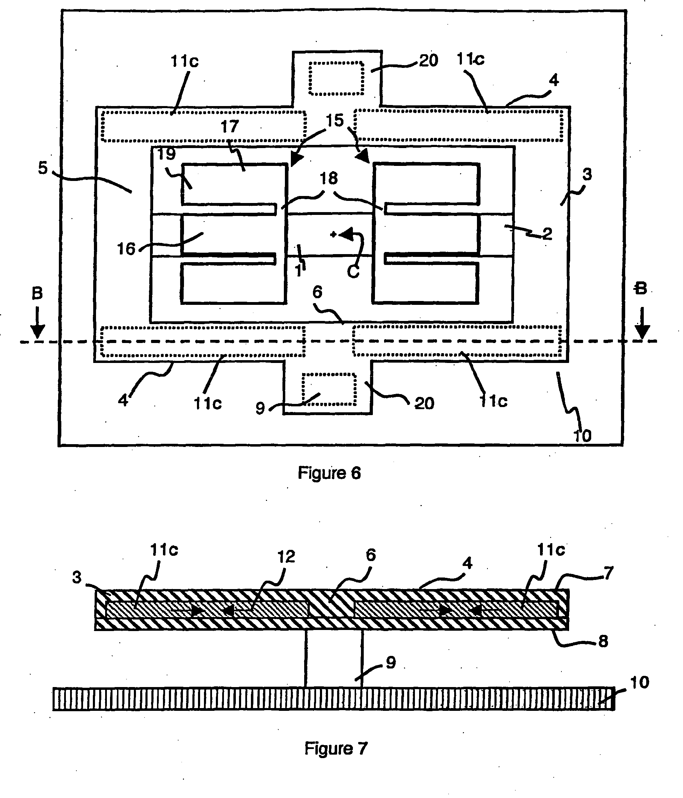

Sur la figure 6, les seconds actionneurs 15 d'un micro-commutateur comportent des électrodes d'actionnement comportant chacune, transversalement à la poutre 1, une zone centrale 16 disposée sur la poutre 1 et deux ailes 17 latérales souples en saillie. Chaque aile 17 latérale est rattachée à la zone centrale 16 correspondante par une zone de liaison 18 plus étroite, disposée d'un côté de l'aile 17 le plus proche du centre C de la poutre 1. Lorsqu'une tension électrique d'actionnement est appliquée entre les électrodes d'actionnement des seconds actionneurs 15 et des contre-électrodes disposées sur le support 10, les extrémités libres 19 des ailes 17 latérales fléchissent en direction du support 10 et, ainsi, la force attractive électrostatique aux extrémités libres 19 augmente. Ainsi, les extrémités libres 19 fléchissent davantage et entraînent la poutre 1 en direction du support 10, la force correspondante entre les ailes 17 et la poutre 1 étant transmise par l'intermédiaire des zones de liaison 18. L'ajout des ailes 17 latérales permet davantage de diminuer la tension électrique d'actionnement du commutateur.

Sur la figure 6, la partie médiane 6 de chaque bras 4 comporte une extension latérale 20. Les extensions latérales 20 sont, par exemple, disposées dans le plan du cadre 3 et les socles 9 sont disposés sous les extensions latérales 20 des bras 4. Ainsi, les parties médianes 6 sont reliées aux socles par l'intermédiaire des extensions latérales 20. On peut également envisager de rattacher l'extension latérale 20 directement au support 10 de base, de manière à ce que la poutre 1 et au moins les extrémités 5 des bras 4 soient à l'écart du support de base 10. Les extensions latérales 20 peuvent, par exemple, former elles-mêmes un socle. Le support 10 peut comporter une cavité disposée en regard de la poutre 1 mobile.

Sur la figure 6, quatre éléments 11c sous contrainte sont intégrés dans le cadre 3, respectivement deux dans chaque bras 4. Les deux éléments 11c d'un bras 4 sont respectivement disposés de part et d'autre de la partie médiane 6 du bras 4, entre la partie médiane 6 et l'extrémité 5 correspondante. Comme représenté à la figure 7, les deux éléments 11c sont centrés entre la face avant 7 et la face arrière 8 du bras 4 correspondant, de manière à ce que les contraintes créent essentiellement des forces longitudinales dans les bras 4, ce qui permet d'éviter tout effet de type bilame. Il est alors important de disposer les éléments 11c symétriquement par rapport à la fibre neutre des bras 4, c'est-à-dire par rapport au milieu de l'ensemble suspendu. Les éléments 11c sont, de préférence, des éléments actifs, par exemple thermiques, se dilatant lors du passage d'un courant électrique. Les éléments 11c peuvent présenter une forme comportant des méandres. Afin de renforcer le cadre 3, une ou plusieurs couches supplémentaires peuvent être disposées entre les éléments 11c, d'une part, et le matériau constituant respectivement les faces avant 7 et arrière 8 des bras 4, d'autre part.

Les seconds actionneurs 15 peuvent également être disposés de manière à être centrés entre les faces avant et arrière correspondantes, c'est-à-dire les faces avant et arrière de la poutre 1. La poutre 1 peut également être renforcée par l'intermédiaire d'une ou plusieurs couches supplémentaires exposées entre les seconds actionneurs 15, d'une part, et le matériau constituant respectivement les faces avant et arrière de la poutre 1, d'autre part. Les seconds actionneurs 15 sont, par exemple, des éléments actifs thermiques, réalisés, de préférence, simultanément avec les éléments 11.

Afin de réaliser le dispositif selon l'invention, on détermine d'abord approximativement les caractéristiques mécaniques (module de Young et coefficient de Poisson) et les contraintes résiduelles des couches minces que l'on souhaite utiliser. Ceci peut être fait expérimentalement ou théoriquement On choisit des matériaux et des épaisseurs de manière à assurer que le cadre soit très rigide par rapport à la poutre, c'est-à-dire de manière à ce que les contraintes résiduelles du dépôt du matériau de la poutre ne déforment pas le cadre. Les paramètres géométriques de la poutre qui correspondent le mieux à l'application visée peuvent être déterminés par l'intermédiaire d'un modèle théorique, par exemple le modèle mécanique proposé dans l'article « On a tunable Bistable MEMS-Theory and Experiment » de M.T.A. Saif (J. Micromech. Syst., Vol. 9 n°2 June 2000, p.157-170). En particulier, il faut trouver un compromis entre la stabilité et l'énergie nécessaire à l'actionnement. Ensuite, l'ensemble peut être vérifié avec un logiciel de calcul par éléments finis, de préférence par un calcul 3D. Ceci permet de vérifier le fonctionnement du dispositif avec une géométrie plus précise que ne le permet le modèle analytique.

L'invention n'est pas limitée aux modes de réalisation représentés. En particulier, on peut envisager une combinaison des premiers actionneurs passifs ou actifs avec des seconds actionneurs actifs ou passifs.

## Revendications

1. Dispositif micromécanique comportant une poutre (1) mobile rattachée par ses deux extrémités (2) à un cadre (3) et des moyens de contrôle de la flèche de la poutre, la poutre (1) ayant un état de contrainte prédéterminé, dispositif **caractérisé, en ce que** le cadre (3) est plus rigide que la poutre et comporte deux bras (4) ayant chacun deux extrémités (5) respectivement solidaires des deux extrémités (2) de la poutre (1) mobile et ayant chacun une partie médiane (6) disposée entre les deux extrémités (5) du bras (4) correspondant, les bras (4) et leurs parties médianes (6) présentant une face avant (7) et une face arrière (8), la face arrière (8) de la partie médiane (8) de chaque bras (4) étant rattachée à un support (10) de base, les moyens de contrôle de la flèche de la poutre comportant au moins un élément (11) sous contrainte, appartenant au cadre (3) et permettant d'ajuster ledit état de contrainte de la poutre.

2. Dispositif selon la revendication 1, **caractérisé en ce que** l'élément (11) sous contrainte est constitué d'une couche mince sous contrainte en traction.

3. Dispositif selon la revendication 1, **caractérisé en ce que** l'élément (11) sous contrainte est constitué d'une couche mince sous contrainte en compression.

4. Dispositif selon l'une quelconque des revendications 1 à 3, **caractérisé en ce que** l'élément (11) sous contrainte comporte un premier actionneur.

5. Dispositif selon la revendication 4, **caractérisé en ce que** le premier actionneur est choisi parmi les actionneurs thermiques, piézoélectriques, électrostatiques, électrostritifs, électromagnétiques et magnétostrictifs.

6. Dispositif selon l'une des revendications 4 et 5, **caractérisé en ce que** le premier actionneur est constitué d'au moins une couche mince.

7. Dispositif selon la revendication 6, **caractérisé en ce qu'**il comporte des moyens (13) pour appliquer une tension électrique entre deux extrémités de la couche mince constituant le premier actionneur.

8. Dispositif selon l'une quelconque des revendications 1 à 7, **caractérisé en ce que** l'élément (11c) sous contrainte est centré entre la face avant (7) et la face arrière (8) du bras (4) correspondant.

9. Dispositif selon l'une quelconque des revendications 1 à 7, **caractérisé en ce que** le cadre (3) comporte au moins une paire d'éléments (11) sous contrainte avant (11a) et arrière (11b) disposés, l'un en regard de l'autre, respectivement à la face avant (7) et à la face arrière (8) des bras (4).

10. Dispositif selon la revendication 9, **caractérisé en ce que**, les éléments sous contrainte avant (11 a) et arrière (11b) d'une paire d'éléments exerçant respectivement des forces avant et arrière respectivement sur les faces avant et arrière du bras (4) correspondant, les forces avant et arrière exercées par les éléments (11) d'une paire d'éléments (11) sont sensiblement égales.

11. Dispositif selon l'une des revendications 9 et 10, **caractérisé en ce que** chaque bras (4) comporte deux paires d'éléments (11) sous contrainte avant (11a) et arrière (11b) disposées respectivement de part et d'autre de la partie médiane (6) du bras (4) correspondant.

12. Dispositif selon l'une quelconque des revendications 1 à 11, **caractérisé en ce que** la partie médiane (6) de chaque bras (4) comporte une extension latérale (20) rattachée au support (10) de base.

13. Dispositif selon l'une quelconque des revendications 1 à 12, **caractérisé en ce que** la face arrière (8) de la partie médiane (8) de chaque bras (4) est disposée sur un socle (9) solidaire du support (10) de base.

14. Dispositif selon l'une quelconque des revendications 1 à 13, **caractérisé en ce que** des éléments conducteurs sont disposés respectivement à une face Inférieure de la poutre (1) et sur le support (10) de base, de manière à permettre d'établir un contact électrique entre lesdits éléments conducteurs, le dispositif constituant un micro-commutateur.

## Claims

1. A micromechanical device comprising a mobile beam (1) attached via the two ends (2) thereof to a frame (3) and means for controlling the sag of the beam, the beam (1) having a predetermined stressed state, device **characterized in that** the frame (3) is more rigid than the beam and comprises two arms (4) each having two ends (5) respectively secured to the two ends (2) of the mobile beam (1) and each having a middle part (6) arranged between the two ends (5) of the corresponding arm (4), the arms (4) and the middle parts (6) of the arms presenting a front face (7) and a rear face (8), the rear face (8) of the middle part (6) of each arm (4) being attached to a base support (10), the means for controlling the sag of the beam comprising at least one stressed element (11) belonging to the frame (3) and enabling the state of stress of the beam to be adjusted

2. The device according to claim 1, **characterized in that** the stressed element (11) is formed by a tensile stressed thin layer.

3. The device according to claim 1, **characterized in that** the stressed element (11) is formed by a compressive stressed thin layer.

4. The device according to any one of claims 1 to 3, **characterized in that** the stressed element (11) comprises a first actuator.

5. The device according to claim 4, **characterized in that** the first actuator is chosen from thermal actuators, piezoelectric actuators and electrostatic, electrostrictive, electromagnetic and magnetostrictive actuators.

6. The device according to either one of claims 4 and 5, **characterized in that** the first actuator is formed by at least one thin layer.

7. The device according to claim 6, **characterized in that** it comprises means (13) for applying an electric voltage between two ends of the thin layer constituting the first actuator.

8. The device according to any one of claims 1 to 7, **characterized in that** the stressed element (11c) is centred between the front face (7) and the rear face (8) of the corresponding arm (4).

9. The device according to any one of claims 1 to 7, **characterized in that** the frame (3) comprises at least one pair of stressed elements (11), a front element (11a) and a rear element (11b) disposed facing one another respectively on the front face (7) and on the rear face (8) of the arms (4).

10. The device according to claim 9, **characterized in that**, the front (11a) and rear (11b) stressed elements of a pair of elements respectively exerting front and rear forces respectively on the front and rear faces of the corresponding arm (4), the front and rear forces exerted by the elements (11) of a pair of elements (11) are substantially equal.

11. The device according to either one of claims 9 and 10, **characterized in that** each arm (4) comprises two pairs of stressed elements (11), a front element (11a) and a rear element (11b), respectively located on each side of the middle part (6) of the corresponding arm (4).

12. The device according to any one of claims 1 to 11, **characterized in that** the middle part (6) of each arm (4) comprises a lateral extension (20) attached to the base support (10).

13. The device according to any one of claims 1 to 12, **characterized in that** the rear face (8) of the middle part (8) of each arm (4) is arranged on a support block (9) securely affixed to the base support (10).

14. The device according to any one of claims 1 to 13, **characterized in that** conducting elements are arranged respectively on a bottom face of the beam (1) and on the base support (10) so as to enable an electric contact to be established between said conducting elements, the device forming a microswitch.

## Patentansprüche

1. Mikromechanische Vorrichtung, die einen beweglichen Balken (1) umfasst, der an seinen beiden Enden (2) mit einem Rahmen (3) verbunden ist, sowie Mittel zur Kontrolle der Durchbiegung des Balkens, wobei sich der Balken (1) in einem Zustand vorbestimmter Spannung befindet, Vorrichtung, die **dadurch gekennzeichnet ist, dass** der Rahmen (3) steifer ist als der Balken und zwei Arme (4) umfasst, die jeweils zwei Enden (5) haben, die jeweils fest mit den beiden Enden (2) des beweglichen Balkens (1) verbunden sind und jeweils einen Mittelteil (6) aufweisen, der zwischen den beiden Enden (5) des entsprechenden Arms (4) angeordnet ist, wobei die Arme (4) und ihre Mittelteile (6) eine Vorderseite (7) und eine Rückseite (8) aufweisen, wobei die Rückseite (8) des Mittelteils (8) jedes Arms (4) mit einem Basisträger (10) verbunden ist und die Mittel zur Kontrolle der Durchbiegung des Balkens mindestens ein unter Spannung stehendes Element (11) umfassen, das zum Rahmen (3) gehört und die Anpassung des vorgenannten Spannungszustands des Balkens erlaubt.

2. Vorrichtung nach Anspruch 1, **dadurch gekennzeichnet, dass** das unter Spannung stehende Element (11) von einer dünnen, unter Zugspannung stehenden Schicht gebildet wird.

3. Vorrichtung nach Anspruch 1, **dadurch gekennzeichnet, dass** das unter Spannung stehende Element (11) von einer dünnen, unter Druckspannung stehenden Schicht gebildet wird.

4. Vorrichtung nach einem der Ansprüche 1 bis 3, **dadurch gekennzeichnet, dass** das unter Spannung stehende Element (11) eine erste Betätigungseinrichtung umfasst.

5. Vorrichtung nach Anspruch 4, **dadurch gekennzeichnet, dass** die erste Betätigungseinrichtung aus der Gruppe der thermischen, piezoelektrischen, elektrostatischen, elektrostriktiven, elektromagnetischen und magnetostriktiven Betätigungseinrichtungen ausgewählt ist.

6. Vorrichtung nach einem der Ansprüche 4 und 5, **dadurch gekennzeichnet, dass** die erste Betätigungseinrichtung von mindestens einer dünnen Schicht gebildet wird.

7. Vorrichtung nach Anspruch 6, **dadurch gekennzeichnet, dass** sie Mittel (13) zum Anlegen einer elektrischen Spannung zwischen zwei Enden der dünnen Schicht umfasst, die die erste Betätigungseinrichtung bildet.

8. Vorrichtung nach einem der Ansprüche 1 bis 7, **dadurch gekennzeichnet, dass** das unter Spannung stehende Element (11c) zwischen der Vorderseite (7) und der Rückseite (8) des entsprechenden Arms (4) zentriert ist.

9. Vorrichtung nach einem der Ansprüche 1 bis 7, **dadurch gekennzeichnet, dass** der Rahmen (3) mindestens ein Paar unter Spannung stehender Elemente (11) umfasst, und zwar ein vorderes (11a) und ein hinteres (11b), die einander gegenüberliegend jeweils auf der Vorderseite (7) und der Rückseite (8) der Arme (4) angeordnet sind.

10. Vorrichtung nach Anspruch 9, **dadurch gekennzeichnet, dass**, nachdem das unter Spannung stehende vordere Element (11a) und das unter Spannung stehende hintere Element (11b) eines Elementepaars jeweils eine vorderseitige und eine rückseitige Kraft auf die Vorder- und Rückseite des jeweiligen Arms (4) ausüben, die von den Elementen (11) eines Elementepaars (11) ausgeübten vorder- und rückseitigen Kräfte im Wesentlichen gleich sind.

11. Vorrichtung nach einem der Ansprüche 9 und 10, **dadurch gekennzeichnet, dass** jeder Arm (4) zwei Paar unter Spannung stehender Elemente (11), nämlich ein vorderes (11a) und ein hinteres (11b), umfasst, die jeweils beidseits des Mittelteils (6) des jeweiligen Arms (4) angeordnet sind.

12. Vorrichtung nach einem der Ansprüche 1 bis 11, **dadurch gekennzeichnet, dass** der Mittelteil (6) jedes Arms (4) eine seitliche Verlängerung (20) umfasst, die mit dem Basisträger (10) verbunden ist.

13. Vorrichtung nach einem der Ansprüche 1 bis 12, **dadurch gekennzeichnet, dass** die Rückseite (8) des Mittelteils (8) jedes Arms (4) auf einem Sockel angeordnet ist, der fest mit dem Basisträger (10) verbunden ist.

14. Vorrichtung nach einem der Ansprüche 1 bis 13, **dadurch gekennzeichnet, dass** leitende Elemente jeweils auf einer unteren Seite des Balkens und auf dem Basisträger angeordnet sind, um ein elektrisches Kontakt zwischen diesen Elementen zu ermöglichen, wobei die Vorrichtung ein Mikroschalter bildet.
